# EUROPEAN PATENT APPLICATION

(11) **EP 4 583 653 A1**
(43) Date of publication of application: **09.07.2025**
(21) Application number: 25150578.0
(22) Date of filing: 07.01.2025
(51) Int. Cl.: H05K 7/20

(54) **CABINET, ENERGY STORAGE CONVERTER, ENERGY STORAGE SYSTEM, AND PHOTOVOLTAIC POWER GENERATION SYSTEM**

(30) Priority: 08.01.2024 CN 202420046497 U
(71) Applicant: Sungrow Power Supply Co., Ltd., Hefei, Anhui 230088 (CN)
(72) Inventor: ZHANG, Hao, Hefei, 230088 (CN); ZHOU, Huan, Hefei, 230088 (CN); YAN, Longxiang, Hefei, 230088 (CN)
(74) Representative: DREISS Patentanwälte PartG mbB

(57) **Abstract**

A cabinet, an energy storage converter, an energy storage system, and a photovoltaic power generation system are provided. The cabinet includes a cabinet body and a heat exchanger. The cabinet body includes a direct ventilation cavity and an electronic cavity. The direct ventilation cavity is independent from the electronic cavity. The direct ventilation cavity forms at least part of a direct ventilation duct, and two ends of the direct ventilation duct are in communication with outside of the cabinet body. The heat exchanger is provided in the cabinet body and has a first heat exchange channel and a second heat exchange channel. The first heat exchange channel exchanges heat with the outside of the cabinet body, and the electronic cavity is in communication with the second heat exchange channel to exchange heat with the first heat exchange channel. With the cabinet according to the present disclosure, by providing the direct ventilation cavity in direct communication with the outside world for heat dissipation and the relatively independent electronic cavity, a heat dissipation effect of the whole machine can be improved, and a protection level of the electronic cavity can be ensured.

## Description

### FIELD

The present disclosure relates to the technical field of cabinets, and in particular to a cabinet, an energy storage converter, an energy storage system, and a photovoltaic power generation system.

### BACKGROUND

With continuous development of energy storage technologies, the capacity of an energy storage battery is constantly increasing, and the power density of an energy storage inverter also constantly increases. However, with enhancement in the power density, issues in protection and heat dissipation of the energy storage converter have becoming increasingly prominent.

Currently, protection measures for the energy storage inverter mainly include housing protection and dust-filtering meshes, but these measures do not completely solve influence of from the external environment, such as dust and rain, to the device. Meanwhile, as the power density of the energy storage inverter continues to increase, the heat dissipation issue of the device becomes more severe. An excessive temperature of the device may lead to device failures, damage to components, and other problems, seriously affecting stable operation of the system.

Therefore, how to improve protection performance and satisfy heat dissipation requirements of the energy storage inverter while increasing the power density of the energy storage inverter is a critical issue to be addressed.

### SUMMARY

The present disclosure aims to at least solve one of the technical problems in the related art to some extent. Therefore, the present disclosure provides a cabinet for an energy storage converter, which can ensure heat dissipation of the cabinet and can also protect components in the cabinet.

The cabinet for the energy storage converter according to the present disclosure includes a cabinet body and a heat exchanger. The cabinet body includes a direct ventilation cavity and an electronic cavity. The direct ventilation cavity is independent from the electronic cavity. The direct ventilation cavity forms at least part of a direct ventilation duct, and two ends of the direct ventilation duct are in communication with outside of the cabinet body. The heat exchanger is provided in the cabinet body and has a first heat exchange channel and a second heat exchange channel. The first heat exchange channel is configured to exchange heat with the outside of the cabinet body, and the electronic cavity is in communication with the second heat exchange channel to exchange heat with the first heat exchange channel.

With the cabinet for the energy storage converter of the present disclosure, by providing the direct ventilation duct, heat of the direct ventilation cavity and the electronic cavity can be taken away, thereby improving the heat dissipation performance of the cabinet. Meanwhile, the electronic cavity is independent from the direct ventilation cavity, and some high-demand components may be mounted in the electronic cavity to avoid external pollution and improve protection performance of the cabinet.

In some embodiments of the present disclosure, the direct ventilation cavity passes through the electronic cavity. A cavity wall of the direct ventilation cavity is separated from a cavity wall of the electronic cavity, to form an air circulation duct between the cavity wall of the direct ventilation cavity and the cavity wall of the electronic cavity.

In an embodiment, at least one circulating fan is provided in the air circulation duct. The at least one circulating fan is configured to drive an airflow in the air circulation duct to flow in a predetermined direction.

According to some embodiments of the present disclosure, the cabinet body is provided with an end chamber located at a same end of the direct ventilation cavity and the electronic cavity, and has a direct ventilation inlet and a direct ventilation outlet. The end chamber is in communication with the outside of the cabinet body through the direct ventilation inlet. The direct ventilation cavity is in communication with the outside of the cabinet body through the direct ventilation outlet, and the end chamber is in communication with the direct ventilation cavity to form the direct ventilation duct.

In an embodiment, the heat exchanger is disposed in the end chamber, and the first heat exchange channel is in communication with the direct ventilation duct.

According to some embodiments of the present disclosure, at least one direct ventilation fan is provided in the direct ventilation duct.

According to some embodiments of the present disclosure, the end chamber includes a first end sub-chamber and a second end sub-chamber that are independent from each other. The first end sub-chamber is in communication with the outside of the cabinet body through the direct ventilation inlet. The second end sub-chamber is in communication with the first heat exchange channel. The cabinet body has a heat exchange air inlet and a heat exchange air outlet. The second end sub-chamber is in communication with the outside of the cabinet body through the heat exchange air inlet. The first heat exchange channel is in communication with the outside of the cabinet body through the heat exchange air outlet. A heat exchange fan is provided in the second end sub-chamber, and is configured to drive an airflow to flow through the heat exchange air inlet, the first heat exchange channel, and the heat exchange air outlet.

According to some embodiments of the present disclosure, the cabinet body includes an outer side wall and a separating wall, the separating wall being configured to separate the end chamber from the electronic cavity. The heat exchanger is disposed in the electronic cavity or the second end sub-chamber, and the heat exchanger is mounted at the outer side wall or the separating wall.

In an embodiment, the cabinet body includes an outer side wall. The heat exchanger is mounted outside the outer side wall. The cabinet further includes a heat exchange fan. The heat exchange fan is located outside the cabinet body and configured to drive an airflow to flow through the first heat exchange channel.

The present disclosure further provides an energy storage converter having the above cabinet. The energy storage converter includes a first device disposed in the direct ventilation cavity and a second device disposed in the electronic cavity. The cabinet has the same advantages as the above-described cabinet compared with the prior art, and details are omitted herein.

The present disclosure further provides an energy storage system. The energy storage system includes the energy storage converter in the above embodiments.

The present disclosure further provides a photovoltaic power generation system. The photovoltaic power generation system includes the energy storage converter in the above embodiments.

Additional aspects and advantages of the present disclosure will be provided in part in the following description, or will become apparent in part from the following description, or can be learned from practicing of the present disclosure.

### BRIEF DESCRIPTION OF THE DRAWINGS

FIG. 1 is a schematic structural diagram of a cabinet according to an embodiment of the present disclosure.
FIG. 2 is a schematic structural diagram of a cabinet according to another embodiment of the present disclosure.
FIG. 3 is a schematic structural diagram of a cabinet according to another embodiment of the present disclosure.
FIG. 4 is a schematic structural diagram of a cabinet according to another embodiment of the present disclosure.
FIG. 5 is a schematic structural diagram of a cabinet according to another embodiment of the present disclosure.
FIG. 6 is a schematic structural diagram of a cabinet according to another embodiment of the present disclosure.
FIG. 7 is a schematic structural diagram of a cabinet according to another embodiment of the present disclosure.

### Reference numerals:

cabinet 1000;
cabinet body 100, outer side wall 110, separating wall 120;
direct ventilation cavity 200, first direct ventilation sub-chamber 210, second direct ventilation sub-chamber 220, electronic cavity 300, first electronic sub-chamber 310, second electronic sub-chamber 320, direct ventilation duct 400, first channel 410, second channel 420, direct ventilation inlet 430, direct ventilation outlet 440, direct ventilation fan 450, connection opening 460, air circulation duct 500, circulating fan 510, heat exchanger 600, first heat exchange channel 610, second heat exchange channel 620, heat exchange air inlet 630, heat exchange air outlet 640, end chamber 700, first end sub-chamber 710, second end sub-chamber 720, heat exchange fan 800;
predetermined direction F 1.

### DETAILED DESCRIPTION

Embodiments of the present disclosure will be described in detail below with reference to examples thereof as illustrated in the accompanying drawings, throughout which same or similar elements, or elements having same or similar functions, are denoted by same or similar reference numerals. The embodiments described below with reference to the drawings are illustrative merely, and are intended to explain, rather than limiting, the present disclosure.

In the description of the embodiments of the present disclosure, the terms "first" and "second" are only used for description purposes, and cannot be understood as indicating or implying relative importance or implying the number of indicated technical features. Therefore, the features associated with "first" and "second" may explicitly or implicitly include at least one of the features. In the description of the present disclosure, "a plurality of' means two or more than two, unless specified otherwise.

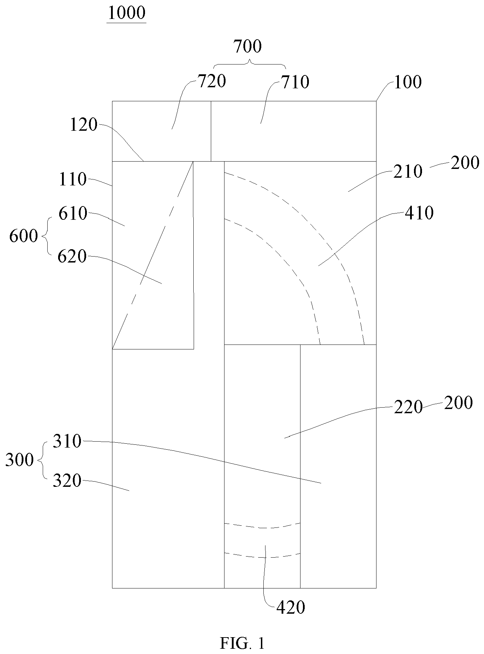

A cabinet 1000 for an energy storage converter according to the embodiments of the present disclosure is described in detail with reference to FIG. 1 to FIG. 7.

Referring to FIG. 1 to FIG. 7, the cabinet 1000 includes a cabinet body 100 and a heat exchanger 600. The heat exchanger 600 is mounted in the cabinet body 100. Heat exchange is performed for the cabinet body 100 by using the heat exchanger 600, facilitating timely discharge of heat in the cabinet body 100, which is beneficial to heat dissipation inside the cabinet body 100.

The cabinet body 100 includes a direct ventilation cavity 200 and an electronic cavity 300. The direct ventilation cavity 200 is independent from the electronic cavity 300. The direct ventilation cavity 200 and the electronic cavity 300 participate in forming two different air ducts in the cabinet body 100, and the air ducts may dissipate heat of the direct ventilation cavity 200 and the electronic cavity 300 and accelerate airflow circulation in the respective cavities. By changing the internal structure of the cabinet body 100, reasonable planning is made for the heat dissipation of different cavities, which is beneficial to improving the heat dissipation efficiency inside the cabinet body 100.

The direct ventilation cavity 200 forms at least part of a direct ventilation duct 400. In an embodiment, the direct ventilation duct 400 is disposed in the cabinet body 100, and two ends of the direct ventilation duct 400 are in communication with outside of the cabinet body 100. In this way, outside air can enter the direct ventilation duct 400 and flow out of the direct ventilation duct 400 to the outside of the cabinet body 100 to form a flowing heat exchange airflow. When a first device is mounted in the direct ventilation cavity 200, the heat exchange airflow may take away heat of the first device when flowing through the first device.

In an embodiment, the direct ventilation cavity 200 may be divided into multiple chambers that are in communication with each other. At least one device may be provided in each chamber, and heat generated by the devices in respective chambers are dissipated through the direct ventilation duct 400. In this embodiment, the direct ventilation cavity 200 is divided into a first direct ventilation sub-chamber 210 and a second direct ventilation sub-chamber 220 that are in communication with each other. Of course, in some embodiments not shown in the drawings, the direct ventilation cavity 200 may alternatively be an entire chamber without being divided, or may be divided into three, four, or more chambers.

The direct ventilation cavity 200 forms at least part of the direct ventilation duct 400, which allows the direct ventilation cavity 200 and the direct ventilation duct 400 to be in communication with each other, and further causes the direct ventilation cavity 200 to be in direct communication with the outside world through the direct ventilation duct 400, forming a direct air circulation environment, thereby strengthening heat dissipation of the direct ventilation cavity 200.

It should be understood that when there is a temperature difference between the direct ventilation cavity 200 and the electronic cavity 300, heat transfer occurs between the direct ventilation cavity 200 and the electronic cavity 300. Specifically, heat transfers from a heat source cavity having a higher temperature to a cavity having a lower temperature through a side wall in contact with the two cavities, to realize heat exchange. For example, the electronic cavity 300 is a closed cavity, while the direct ventilation duct 400 has circulation of a direct-ventilation airflow, such that a temperature of the direct ventilation cavity 200 is made lower than a temperature of the electronic cavity 300. The electronic cavity 300 transfers superfluous heat to the direct ventilation cavity 200 through heat exchange. The heat of the direct ventilation cavity 200 may be further carried to the outside world by the direct-ventilation airflow in the direct ventilation duct 400, thereby realizing heat dissipation of the cabinet 1000. In the related art, all internal cavities of the cabinet are fully closed cavities which exchange heat with the outside world through the heat exchanger. This heat dissipation method cannot meet heat dissipation requirements of a component with large heat productivity inside the cavity, increasing the risk of component damage. In the embodiments of the present disclosure, the direct ventilation cavity 200 is provided, and the component with large heat productivity may be arranged in the direct ventilation cavity 200. The heat produced by the component may be brought to the outside world by the direct-ventilation airflow in the direct ventilation duct 400 to realize heat dissipation, which improves the heat dissipation effect. The direct-ventilation airflow in the direct ventilation duct 400 does not interfere with the heat dissipation of the electronic cavity 300 through the heat exchanger 600.

The heat exchanger 600 has a first heat exchange channel 610 and a second heat exchange channel 620. The first heat exchange channel 610 is configured to exchange heat with the outside of the cabinet body 100, and the electronic cavity 300 is in communication with the second heat exchange channel 620 to exchange heat with the first heat exchange channel 610. This is because air flows with two different temperatures passing through the first heat exchange channel 610 and the second heat exchange channel 620 are in contact with each other at a wall surface of the heat exchanger 600. Heat is transferred from the high-temperature air flow to the low-temperature air flow until the temperatures of the two air flows reach equilibrium, thus completing the heat exchange. Specifically, the outside air may enter the first heat exchange channel 610 to take away superfluous heat of the heat exchanger 600. An air flow in the electronic cavity 300 may transfer superfluous heat of the electronic cavity 300 to the second heat exchange channel 620 when flowing through the second heat exchange channel 620. Superfluous heat of the second heat exchange channel 620 may be further transferred to the first heat exchange channel 610, and then carried to the outside world by the airflow in the first heat exchange channel 610.

With the cabinet 1000 for the energy storage converter according to the present disclosure, the direct ventilation duct 400 and the relatively independent electronic cavity 300 are provided, such that heat dissipation is performed on components with large heat productivity in the cabinet 1000 through the direct ventilation duct 400, and important components may be provided in the electronic cavity 300 for independent protection. The direct ventilation duct 400 also dissipates heat in the electronic cavity 300 by exchanging heat with the electronic cavity 300, so that the cabinet 1000 takes into account functions of both heat dissipation and protection. In other words, by providing the direct ventilation duct 400, heat of the direct ventilation cavity 200 and the electronic cavity 300 may be taken away, and heat dissipation performance of the cabinet 1000 is improved. Meanwhile, the electronic cavity 300 is independent from the direct ventilation cavity 200, and some high-demand components may be mounted in the electronic cavity 300, to avoid external pollution and improve protection performance of the cabinet 1000.

In some embodiments of the present disclosure, the direct ventilation cavity 200 passes through the electronic cavity 300, and a cavity wall of the direct ventilation cavity 200 is separated from a cavity wall of the electronic cavity 300, to form an air circulation duct 500 between the cavity wall of the direct ventilation cavity 200 and the cavity wall of the electronic cavity 300. The air circulation duct 500 surrounds the direct ventilation cavity 200, and the duct arrangement of the direct ventilation cavity 200 does not interfere with the electronic cavity 300.

According to different requirements for protection levels of the components in the cabinet 1000, the components are classified and disposed in the closed electronic cavity 300 and the open direct ventilation cavity 200. The electronic cavity 300 performs internal circulation and exchanges heat with the outside world through the heat exchanger 600, which not only ensures the protection level of the electronic cavity 300, but also realizes heat exchange. The direct ventilation cavity 200 is in communication with the outside world, and does not interfere with the internal air circulation duct of the electronic cavity 300 in structure. The components stored according to classification reduce design requirements and cost of the heat exchanger 600, and improve the overall heat exchange efficiency of the cabinet 1000.

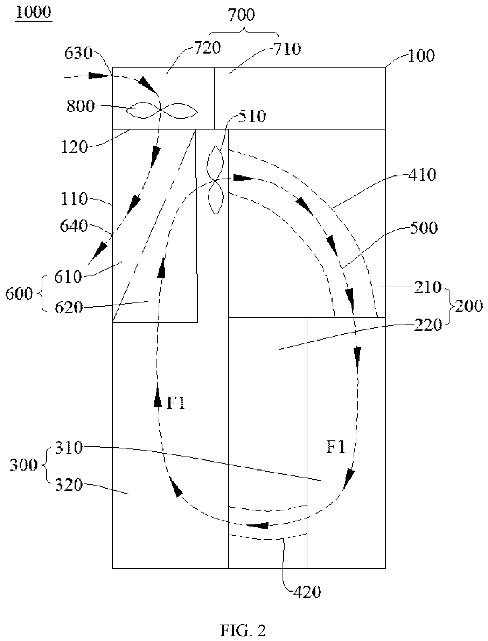

Referring to FIG. 1 to FIG. 4, in the cabinet 1000 according to some embodiments of the present disclosure, the electronic cavity 300 includes a first electronic sub-chamber 310, a second electronic sub-chamber 320, a first channel 410, and a second channel 420. The first electronic sub-chamber 310 and the second electronic sub-chamber 320 are located at left and right sides of the direct ventilation cavity 200, respectively. A cavity wall of the direct ventilation cavity 200 at a front side of the direct ventilation cavity 200, which is, for example, an upstream side relative to the airflow direction in the air circulation duct, is separated from the cavity wall of the electronic cavity 200 to form the first channel 410. A cavity wall of the direct ventilation cavity 200 at a rear side of the direct ventilation cavity 200, which is, for example, a downstream side relative to the airflow direction in the air circulation duct, is separated from the cavity wall of the electronic cavity 300 to form the second channel 420. The first electronic sub-chamber 310, the first channel 410, the second electronic sub-chamber 320, and the second channel 420 surround the direct ventilation cavity 200. The first electronic sub-chamber 310 is in communication with the second electronic sub-chamber 320 through the first channel 410, and the first electronic sub-chamber 310 is in communication with the second electronic sub-chamber 320 through the second channel 420, to form the air circulation duct 500 in the first electronic sub-chamber 310, the first channel 410, the second electronic sub-chamber 320, and the second channel 420. The first channel 410 and the second channel 420 causes the first electronic sub-chamber 310 to be in communication with the second electronic sub-chamber 320. As shown in FIG. 2, an airflow in the air circulation duct 500 circulates in the clockwise direction, and sequentially passes through the first electronic sub-chamber 310, the second channel 420, the second electronic sub-chamber 320, and the first channel 410 and continuously circulates along this path. Of course, in some embodiments not shown in the drawing, the airflow within the air circulation duct 500 may also circulate in the counterclockwise direction, and sequentially pass through the first electronic sub-chamber 310, the first channel 410, the second electronic sub-chamber 320, and the second channel 420 sequentially and continuously circulate along this path. Through this design, the electronic cavity 300 is isolated from the outside world, which can ensure a relatively stable and pollution-free operation environment of the electronic cavity 300. Therefore, a second device with relatively high requirements for dustproofing, waterproofing, anti-corrosion, or anti-pollution may be provided in the electronic cavity 300, thereby improving a protection level of the entire cabinet 1000.

In some embodiments not shown in the drawings, the electronic cavity 300 may further include multiple sub-cavities in communication with each other, to arrange different components in different sub-cavities to prevent mutual interference due to the small distance between different components.

In an embodiment, at least one circulating fan 510 is provided in the air circulation duct 500. The at least one circulating fan 510 is configured to drive an airflow in the air circulation duct 500 to flow in a predetermined direction F1. The predetermined direction F1 refers to a direction of a loop along an interior of the air circulation duct 500. When the airflow in the air circulation duct 500 circulates, the airflow flows through the first channel 410 and the second channel 420. At this time, a side wall of the first channel 410 is connected to the direct ventilation duct 400, and when the airflow in the air circulation duct 500 circulates, the heat flows through the first channel 410 along the air circulation duct 500. At this time, a temperature difference occurs between the first channel 410 and the direct ventilation duct 400, and the heat is transferred from the air circulation duct 500 to the side wall between the first channel 410 and the direct ventilation duct 400, then is transferred from the side wall to the airflow passing through the direct ventilation duct 400, and finally is carried to the outside world by the airflow, completing a heat dissipation process within the air circulation duct 500. Similarly, the heat in the second channel 420 is also transferred to the airflow passing through the direct ventilation duct 400 and then carried to the outside world by the airflow.

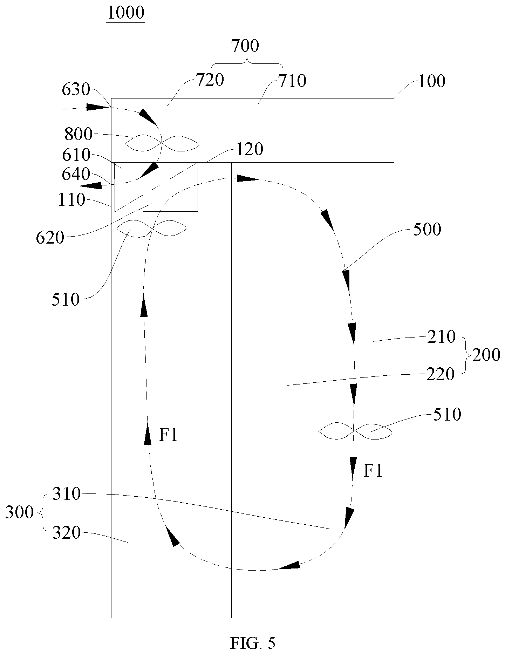

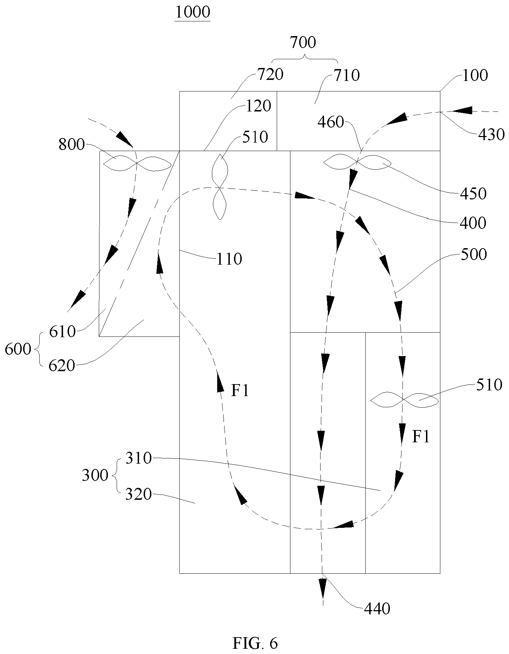

Referring to FIG. 5 and FIG. 6, in a cabinet 1000 according to an embodiment of another aspect of the present disclosure, the circulating fan 510 is provided in each of the first electronic sub-chamber 310 and the second electronic sub-chamber 520, and is configured to drive the airflow in the air circulation duct 500 to flow in the predetermined direction F1. In an embodiment, a circulation surface of the circulating fan 510 is perpendicular to a circulation direction of the airflow in the air circulation duct 500, to accelerate the circulation of the airflow, which accelerates contact frequency between the airflow in the air circulation duct 500 and the direct ventilation cavity 200, is beneficial to improving the heat exchange efficiency, and realizes effective heat dissipation.

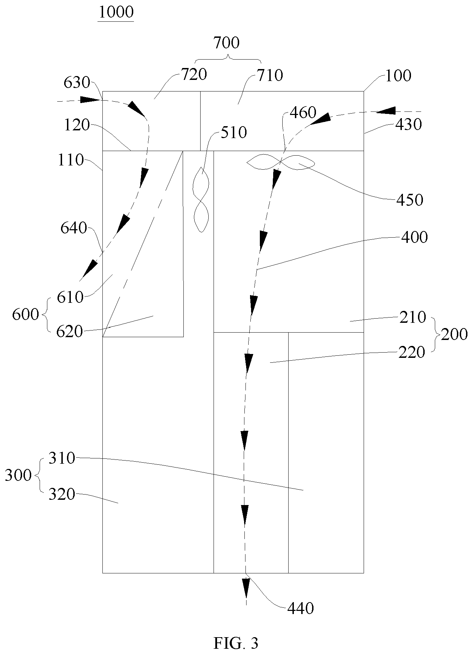

Referring to FIG. 1 to FIG. 7, in a cabinet 1000 according to other embodiments of the present disclosure, the cabinet body 100 is provided with an end chamber 700 located at a same end of the direct ventilation cavity 200 and the electronic cavity 300. For example, in specific examples of FIG. 1 to FIG. 7, the end chamber 700 is located at a top end of the direct ventilation cavity 200 and a top end of the electronic cavity 300. In some embodiments not shown in the drawings, the end chamber 700 may also be located at a bottom end or a side end of each of the direct ventilation cavity 200 and the electronic cavity 300. Referring to FIG. 3, FIG. 4, and FIG. 6, the cabinet body 100 has a direct ventilation inlet 430 and a direct ventilation outlet 440. The end chamber 700 is in communication with the outside of the cabinet body 100 through the direct ventilation inlet 430. The direct ventilation cavity 200 is in communication with the outside of the cabinet body 100 through the direct ventilation outlet 440. The end chamber 700 is in communication with the direct ventilation cavity 200 to form the direct ventilation duct 400. Since the end chamber 700 provides an air buffer region, the outside air is more evenly distributed when entering the cabinet 1000, to avoid generation of impact and interference of the airflow to the first device disposed in the direct ventilation cavity 200 when the airflow enters the direct ventilation cavity 200, improving operation stability of the first device. Further, the end chamber 700 may absorb and buffer noise generated by the airflow when circulating in the direct ventilation chamber 200, thereby improving silent performance of the cabinet 1000.

In an embodiment, the end chamber 700 may also be used as a separate filtering region to improve waterproof and dustproof effects of the whole machine, thereby reducing a risk of contamination of electronic components inside the cabinet 1000, and prolonging a service live of each electronic component.

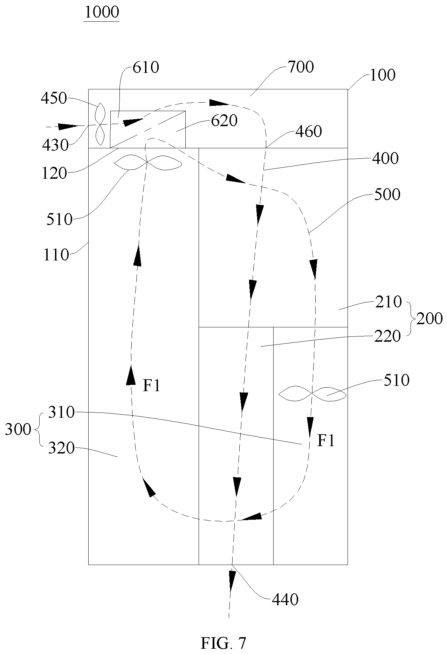

Referring to FIG. 7, in a cabinet 1000 according to an embodiment of another aspect of the present disclosure, the heat exchanger 600 is disposed in the end chamber 700, and the direct ventilation duct 400 is in communication with the first heat exchange channel 610 in the heat exchanger 600 through a connection opening 460. With this arrangement, the first heat exchange channel 610 is located on the direct ventilation duct 400, and the outside air passes through the first heat exchange channel 610 and the connection opening 460 and then enters the direct ventilation duct 400. At this time, the first heat exchange channel 610 exchanges heat with the second heat exchange channel 620, to take away the superfluous heat in the electronic cavity 300. When entering the direct ventilation cavity 200, the outside air also interacts with the electronic cavity 300, leading to another heat exchange. Finally, heat absorbed through multiple heat exchanges is carried out of the cabinet 100 from the direct ventilation outlet 440, strengthening the heat dissipation effect.

In an embodiment, referring to FIG. 7, the first heat exchange channel 610 of the heat exchanger 600 and the direct ventilation duct 400 share one direct ventilation inlet 430. The outside air enters the end chamber 700 through the direct ventilation inlet 430, then enters the first heat exchange channel 610 of the heat exchanger 600, then flows to the direct ventilation cavity 200, and finally flows out from the direct ventilation outlet 440.

In an embodiment, at least one direct ventilation fan 450 is provided in the direct ventilation duct 400. In embodiments of FIG. 3, FIG. 4, and FIG. 6, only one direct ventilation fan 450 is disposed in the direct ventilation duct 400, and the direct ventilation fan 450 is disposed in the direct ventilation cavity 200. In the embodiment of FIG. 7, the first heat exchange channel 610 is located on the direct ventilation duct 400. In this way, only one direct ventilation fan 450 can be provided in the end chamber 700, without the need to provide the fan in each of the end chamber 700 and the direct ventilation cavity 200, which reduces the quantity of fans and reduces the cost. Meanwhile, accumulation of additional heat in the cabinet 1000 brought by multiple fans disposed in multiple channels, which increase the heat exchange load of the heat exchanger 600, is avoided. Of course, in order to increase a wind speed, the direct ventilation fan 450 may be provided in each the end chamber 700 and the direct ventilation chamber 200.

Referring to FIG. 3, FIG. 4, FIG. 6, and FIG. 7, in a cabinet 1000 according to some embodiments of the present disclosure, the end chamber 700 includes a first end sub-chamber 710 and a second end sub-chamber 720 that are independent from each other. The first end sub-chamber 710 is in communication with the outside of the cabinet body 100 through the direct ventilation inlet 430. In this structure, the direct ventilation duct 400 has one separate direct ventilation inlet 430, and the direct ventilation inlet 430 is disposed on a cavity wall of the first end sub-chamber 710. In this way, the direct ventilation duct 400 has a relatively large air inlet volume to ensure the heat exchange effect. Meanwhile, the direct ventilation air inlet 430 located at the cavity wall of the first end sub-chamber 710 also facilitates later maintenance and reduces maintenance difficulty of the direct ventilation duct 400.

In an embodiment, referring to FIG. 2 to FIG. 5, the second end sub-chamber 720 is in communication with the first heat exchange channel 610. The cabinet body 100 has a heat exchange air inlet 630 and a heat exchange air outlet 640. The second end sub-chamber 720 is in communication with the outside of the cabinet body 100 through the heat exchange air inlet 630. The heat exchange air inlet 630 is located at a cavity wall of the second end sub-chamber 720, and the heat exchanger 600 is disposed in the second end sub-chamber 720, which is beneficial to improving the dustproof and waterproof effects of the heat exchanger 600, prolonging the service life. The outside air enters the second end sub-chamber 720 through the heat exchange air inlet 630 and then enters the first heat exchange channel 610.

The first heat exchange channel 610 is in communication with the outside of the cabinet body 100 through the heat exchange air outlet 640. In this way, the airflow in the first heat exchange channel 610 can flow out to the outside of the cabinet body 100 through the heat exchange air outlet 640, thereby realizing the heat dissipation of the heat exchanger 600. A heat exchange fan 800 is provided in the second end sub-chamber 720 and is configured to drive the airflow to flow through the heat exchange air inlet 630, the first heat exchange channel 610, and the heat exchange air outlet 640, which improves air intake and outlet stability of the first heat exchange channel 610, allowing an outside low-temperature air to enter the first heat exchange channel 610 continuously and stably, thereby ensuring heat exchange efficiency between the first heat exchange channel 610 and the electronic cavity 300. It is worth noting that an airflow direction of the air circulation duct 500 in the electronic cavity 300 is opposite to an airflow direction in the first heat exchange channel 610, so that a heat exchange area may be utilized to the maximum extent. In this case of countercurrent heat exchange, a cold airflow and a hot airflow flow in opposite directions, such that the heat is fully exchanged, improving the heat exchange efficiency. Secondly, in an embodiment, referring to FIG. 2 to FIG. 5, both end openings of the first heat exchange channel 610 are formed at a same side of the cabinet 1000, which can reduce a design length of the first heat exchange channel 610, and is beneficial to reducing the cost. This compact design reduces a volume of the cabinet 1000, improves use flexibility of the cabinet 1000, and ensures the heat exchange efficiency.

In an embodiment, the cabinet body 100 includes an outer side wall 110 and a separating wall 120. The separating wall 120 is configured to separate the end chamber 700 from the electronic cavity 300. When the heat exchanger 600 is disposed in the electronic cavity 300, the heat exchanger 600 may be mounted at an inner surface of the outer side wall 110, as shown in FIG. 1 to FIG. 4. The heat exchanger 600 may alternatively be mounted on the separating wall 120. As shown in FIG. 5, the heat exchanger 600 is mounted under the separating wall 120, and the outside air passes through the heat exchange air inlet 630 and the first heat exchange channel 610 and then flows out of the heat exchange air outlet 640. When the heat exchanger 600 is disposed in the electronic cavity 300, the heat exchanger 600 does not occupy a space of the end chamber 700, which can save more effective space of the end chamber 700, and does not affect the air buffer effect of the end chamber 700. Meanwhile, when the heat exchanger 600 is mounted on the separating wall 120, limitation on the arrangement of the heat exchanger 600 due to a cabinet door on the outer side wall 110 can be avoided.

In an embodiment, the heat exchanger 600 is disposed in the second end sub-chamber 720. In this case, the heat exchanger 600 is mounted at the separating wall 120, and the electronic cavity 300 may realize heat exchange with the heat exchanger 600 through a through hole formed on the separating wall 120, or the electronic cavity 300 may realize heat dissipation only through heat exchange between the electronic cavity 300 and the heat exchanger 600 without forming the through hole on the separating wall 120. Referring to FIG. 7, the heat exchanger 600 is mounted above the separating wall 120. It can be seen that, with this arrangement, the heat exchanger 600 utilizes a space of the second end sub-chamber 720 while saving an occupied space in the electronic cavity 300, and more parts may be accommodated in the electronic cavity 300, thereby improving a space utilization rate.

Referring to FIG. 6, in a cabinet 1000 according to some embodiments of the present disclosure, the cabinet body 100 includes an outer side wall 110. The heat exchanger 600 is mounted outside the outer side wall 110. The cabinet 1000 further includes a heat exchange fan 800. The heat exchange fan 800 is located outside the cabinet body 100 and configured to drive the airflow to flow through the first heat exchange channel 610. Firstly, a space occupied by the heat exchanger 600 inside the cabinet 1000 is reduced, especially when there are many components in the electronic cavity 300, making the internal space limited. With this arrangement, the layout of the device is optimized. Secondly, independent maintenance and replacement of the heat exchanger 600 by staff are facilitated, and overall maintenance requirements for the cabinet 1000 are reduced.

In an embodiment, the heat exchanger 600 in the above embodiment uses a flat tube heat exchanger or a conventional aluminum foil heat exchanger. Generally, the flat tube heat exchanger has high heat transfer efficiency, a light weight, and good stability. The conventional aluminum foil heat exchanger has a compact structure and a large heat exchange area per unit volume and may be directly connected to pipelines, making installation convenient. Therefore, the heat exchanger 600 can be selected according to customer's needs.

According to some embodiments of another aspect of the present disclosure, an energy storage converter is provided. The energy storage converter includes a cabinet 1000, a first device, and a second device. The cabinet 1000 is the cabinet 1000 in the above-described embodiments. Each of the first device and the second device is disposed in the cabinet 1000. The first device is disposed in the direct ventilation cavity 200, and the second device is disposed in the electronic cavity 300. The first device includes at least one of an inverter power unit and a reactance unit, and the second device is an electronic component. It can be seen that both the inverter power unit and the reactance unit are components with a large heat generation amount. The inverter power unit and the reactance unit are disposed in the direct ventilation cavity 200, which is beneficial to quick discharge of heat of the inverter power unit and the reactance unit from the cabinet 1000, providing a prerequisite for the heat dissipation of the whole cabinet 1000. The electronic components usually need to be protected emphatically. Therefore, the components are arranged in the closed electronic cavity 300, which provides a relatively stable and pollution-free operation environment for the electronic components, and solves a problem of negative influence of the external environment on the electronic components. Meanwhile, the heat in the electronic cavity 300 is discharged by using the heat exchanger 600, which further improves the heat dissipation efficiency of the whole machine and ensures the operation stability of the whole machine.

In some embodiments, the direct ventilation cavity 200 is divided into a first direct ventilation sub-chamber 210 and a second direct ventilation sub-chamber 220 that are in communication with each other. The first device includes an inverter power unit and a reactance unit. The inverter power unit is disposed in the first direct ventilation sub-chamber 210, and the reactance unit is disposed in the second direct ventilation sub-chamber 220.

### First embodiment

A cabinet 1000 according to a first embodiment of the present disclosure is described below with reference to FIG. 2. The cabinet 1000 includes a cabinet body 100 and a heat exchanger 600. The cabinet body 100 includes an outer side wall 110 on a side and a separating wall 120 formed in the cabinet body 100. The separating wall 120 divides the interior of the cabinet body 100 into an upper part and a lower part. An end chamber 700 is formed above the separating wall 120 and includes a first end sub-chamber 710 and a second end sub-chamber 720. A direct ventilation cavity 200 and an electronic cavity 300 are formed under the separating wall 120. The electronic cavity 300 is independent from other cavities. The direct ventilation cavity 200 includes a first direct ventilation sub-chamber 210 and a second direct ventilation sub-chamber 220 that are in communication with each other. The direct ventilation cavity 200 is configured to form a direct ventilation duct 400 in the cabinet 100, and two ends of the direct ventilation duct 400 are a direct ventilation inlet 430 and a direct ventilation outlet 440, respectively. The direct ventilation inlet 430 is formed at the first end sub-chamber 710, and the direct ventilation outlet 440 is formed at a bottom of the cabinet body 100.

The electronic cavity 300 includes a first electronic sub-chamber 310 and a second electronic sub-chamber 320. A first channel 410 and a second channel 420 are further provided in the direct ventilation duct 400. The first electronic sub-chamber 310 is in communication with the second electronic sub-chamber 320 through the first channel 410, and the first electronic sub-chamber 310 is in communication with the second electronic sub-chamber 320 through the second channel 420, thereby forming the air circulation duct 500 in the first electronic sub-chamber 310, the first channel 410, the second electronic sub-chamber 320, and the second channel 420. The circulating fan 510 is provided in the second electronic sub-chamber 320 and disposed at the separating wall 120.

The heat exchanger 600 is disposed in the second electronic sub-chamber 320 and includes a first heat exchange channel 610 and a second heat exchange channel 620. The cabinet body 100 has a heat exchange air inlet 630 and a heat exchange air outlet 640. The heat exchange air inlet 630 is disposed in the second end sub-chamber 720. The heat exchange air outlet 640 is disposed on the outer side wall 110. The second end sub-chamber 720 is also provided with a heat exchange fan 800.

A flat-tube heat exchanger is used as the heat exchanger 600.

### Second embodiment

A cabinet 1000 according to a second embodiment of the present disclosure is described below with reference to FIG. 3. This embodiment is substantially the same as the first embodiment, and also includes a cabinet body 100, an outer side wall 110, a separating wall 120, a direct ventilation cavity 200, a first direct ventilation sub-chamber 210, a second direct ventilation sub-chamber 220, an electronic cavity 300, a first electronic sub-chamber 310, a second electronic sub-chamber 320, a direct ventilation duct 400, a first channel 410, a second channel 420, a direct ventilation inlet 430, a direct ventilation outlet 440, an air circulation duct 500, a circulating fan 510, a heat exchanger 600, a first heat exchange channel 610, a second heat exchange channel 620, a heat exchange air inlet 630, a heat exchange air outlet 640, an end chamber 700, a first end sub-chamber 710, and a second end sub-chamber 720. The cabinet 1000 according to the second embodiment differs from the cabinet 1000 of the first embodiment in that no heat exchange fan 800 is provided in the second end sub-chamber 720. Meanwhile, a direct ventilation fan 450 is provided in the first direct ventilation sub-chamber 210 and is located at the separating wall 120.

### Third embodiment

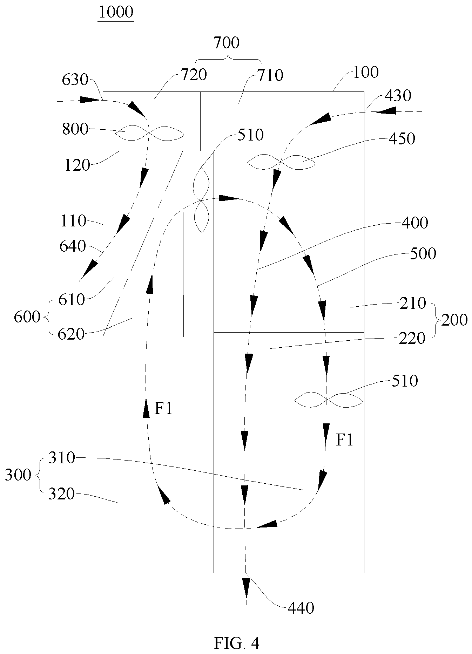

A cabinet 1000 according to a third embodiment of the present disclosure is described below with reference to FIG. 4. This embodiment is substantially the same as the second embodiment, except that two circulating fans 510 are provided in the electronic cavity 300 and are respectively located in the first electronic sub-chamber 310 and the second electronic sub-chamber 320. Moreover, the circulating fan 510 located in the second electronic sub-chamber 320 is mounted on the separating wall 120, and is located at an outlet of the second heat exchange channel 620 of the heat exchanger 600. Meanwhile, a heat exchange fan 800 is provided in the second end sub-chamber 720 and is in communication with the first heat exchange channel 610 of the heat exchanger 600.

### Fourth embodiment

A cabinet 1000 according to a fourth embodiment of the present disclosure is described below with reference to FIG. 5. This embodiment is substantially the same as the third embodiment, except that the heat exchanger 600 is mounted on the separating wall 120, and two circulating fans 510 are arranged in the electronic cavity 300, and are respectively located in the first electronic sub-chamber 310 and the second electronic sub-chamber 320. Moreover, the circulating fan 510 in the second electronic sub-chamber 320 is mounted on the outer side wall 110, and is located at an inlet of the second heat exchange channel 620 of the heat exchanger 600.

### Fifth embodiment

A cabinet 1000 according to a fifth embodiment of the present disclosure is described below with reference to FIG. 6. This embodiment is substantially the same as the fourth embodiment, except that the heat exchanger 600 is located outside the cabinet body 100 and mounted on the outer side wall 110 of the cabinet body 100, and the heat exchange fan 800 is provided in the first heat exchange channel 610 of the heat exchanger 600.

### Sixth embodiment

A cabinet 1000 according to a sixth embodiment of the present disclosure is described below with reference to FIG. 7. This embodiment is substantially the same as the fourth embodiment, except that the heat exchanger 600 is disposed in the end chamber 700, and the first heat exchange channel 610 of the heat exchanger 600 is in communication with the direct ventilation duct 400.

An energy storage system according to an embodiment of another aspect of the present disclosure includes an energy storage converter, which is the energy storage converter in the above-described embodiments. Since the energy storage converter is one of core components in the energy storage system, the energy storage inverter with good heat dissipation performance can improve a utilization rate of the energy storage system, thereby utilizing electric energy more efficiently. Especially in some high-temperature environments, the energy storage inverter with good heat dissipation will not fail due to overheating, thereby improving the stability of the energy storage system.

A photovoltaic power generation system according to an embodiment of another aspect of the present disclosure includes an energy storage system, which is the energy storage system in the above-described embodiments. The energy storage system may store electric energy, and convert the electric energy into required alternating current and release the alternating current when needed. Therefore, an energy storage system with good heat dissipation performance can improve the ability to convert electric energy into alternating current, which can greatly improve power generation efficiency and avoid energy waste.

In the description of the present disclosure, it should be understood that, orientation or position relationship indicated by terms such as "longitudinal", "lateral", "length", "width", "thickness", "over", "below", "front", "back", "left", "right", "vertical", "horizontal", "top", "bottom", "in", "out", etc., is based on the orientation or position relationship shown in the accompanying drawings, and is merely for the convenience of describing the present disclosure and simplifying the description, rather than indicating or implying that the associated device or element must have a specific orientation, or be constructed and operated in a specific orientation, and therefore should be understood as a limitation on the present disclosure.

In the present disclosure, unless specified or limited otherwise, the terms "mounted", "connected", "coupled", and "fixed" should be understood in a broad sense. For example, it may be a fixed connection or a detachable connection or connection as one piece; mechanical connection or electrical connection or intercommunication; direct connection or indirect connection through an intermediate; internal communication of two components or the interaction relationship between two components. For those skilled in the art, the specific meaning of the above-mentioned terms in the present disclosure can be understood according to specific circumstances.

In the description of this specification, descriptions with reference to the terms "an embodiment", "some embodiments", "examples", "specific examples", or "some examples", etc. mean that specific features, structure, materials, or characteristics described in conjunction with the embodiment or example are included in at least one embodiment or example of the present disclosure. In this specification, the schematic representations of the above terms do not necessarily refer to the same embodiment or example. Moreover, the described specific features, structures, materials or characteristics may be combined in any one or more embodiments or examples in a suitable manner. In addition, those skilled in the art can combine the different embodiments or examples described in this specification.

Although the embodiments of the present disclosure have been shown and described above, it can be understood that the above-mentioned embodiments are exemplary and should not be construed as limiting the present disclosure, and changes, modifications, substitutions, and variations can be made by those skilled in the art to the embodiments without departing from the scope of the present disclosure.

## Claims

1. A cabinet (1000) for an energy storage converter, comprising:
a cabinet body (100) comprising a direct ventilation cavity (200) and an electronic cavity (300), the direct ventilation cavity (200) being independent from the electronic cavity (300), the direct ventilation cavity (200) forming at least part of a direct ventilation duct (400), and two ends of the direct ventilation duct (400) being in communication with outside of the cabinet body (100); and
a heat exchanger (600) provided in the cabinet body (100) and having a first heat exchange channel (610) and a second heat exchange channel (620), the first heat exchange channel (610) being configured to exchange heat with the outside of the cabinet body (100), and the electronic cavity (300) being in communication with the second heat exchange channel (620) to exchange heat with the first heat exchange channel (610).

2. The cabinet (1000) for the energy storage converter according to claim 1, wherein the direct ventilation cavity (200) passes through the electronic cavity (300), a cavity wall of the direct ventilation cavity (200) being separated from a cavity wall of the electronic cavity (300), to form an air circulation duct (500) between the cavity wall of the direct ventilation cavity (200) and the cavity wall of the electronic cavity (300).

3. The cabinet (1000) for the energy storage converter according to claim 2, wherein at least one circulating fan is provided in the air circulation duct (500), the at least one circulating fan being configured to drive an airflow in the air circulation duct (500) to flow in a predetermined direction.

4. The cabinet (1000) for the energy storage converter according to claim 1, wherein the cabinet body (100) is provided with an end chamber (700) located at a same end of the direct ventilation cavity (200) and the electronic cavity (300), and has a direct ventilation inlet (430) and a direct ventilation outlet (440), the end chamber (700) being in communication with the outside of the cabinet body (100) through the direct ventilation inlet (430), the direct ventilation cavity (200) being in communication with the outside of the cabinet body (100) through the direct ventilation outlet (440), and the end chamber (700) being in communication with the direct ventilation cavity (200) to form the direct ventilation duct (400).

5. The cabinet (1000) for the energy storage converter according to claim 4, wherein the heat exchanger (600) is disposed in the end chamber (700), and the first heat exchange channel (610) is in communication with the direct ventilation duct (400).

6. The cabinet (1000) for the energy storage converter according to claims 1, 4, or 5, wherein at least one direct ventilation fan (450) is provided in the direct ventilation duct (400).

7. The cabinet (1000) for the energy storage converter according to claim 5, wherein:
the end chamber (700) comprises a first end sub-chamber (710) and a second end sub-chamber (720) that are independent from each other, the first end sub-chamber (710) being in communication with the outside of the cabinet body (100) through the direct ventilation inlet (430), the second end sub-chamber (720) being in communication with the first heat exchange channel (610);
the cabinet body (100) has a heat exchange air inlet (630) and a heat exchange air outlet (640), the second end sub-chamber (720) being in communication with the outside of the cabinet body (100) through the heat exchange air inlet (630), the first heat exchange channel (610) being in communication with the outside of the cabinet body (100) through the heat exchange air outlet (640); and
a heat exchange fan is provided in the second end sub-chamber (720), and is configured to drive an airflow to flow through the heat exchange air inlet (630), the first heat exchange channel (610), and the heat exchange air outlet (640).

8. The cabinet (1000) for the energy storage converter according to claim 7, wherein the cabinet body (100) comprises an outer side wall (110) and a separating wall (120), the separating wall (120) being configured to separate the end chamber (700) from the electronic cavity (300), the heat exchanger (600) being disposed in the electronic cavity (300) or the second end sub-chamber (720), and the heat exchanger (600) being mounted at the outer side wall (110) or the separating wall.

9. The cabinet (1000) for the energy storage converter according to claim 4, wherein:
the cabinet body (100) comprises an outer side wall (110), the heat exchanger (600) being mounted outside the outer side wall (110); and
the cabinet (1000) further comprises a heat exchange fan (800), the heat exchange fan (800) being located outside the cabinet body (100) and configured to drive an airflow to flow through the first heat exchange channel (610).

10. An energy storage converter, comprising:
the cabinet (1000) of the energy storage converter according to any one of claims 1 to 9;
a first device disposed in the direct ventilation cavity (200); and
a second device disposed in the electronic cavity (300).

11. An energy storage system, comprising the energy storage converter according to claim 10.

12. A photovoltaic power generation system, comprising the energy storage system according to claim 11.
